# EUROPÄISCHE PATENTSCHRIFT

(11) **EP 0 929 103 B1**
(45) Veröffentlichungstag und Bekanntmachung des Hinweises auf die Patenterteilung: **02.05.2002**
(21) Anmeldenummer: 99100301.3
(22) Anmeldetag: 08.01.1999
(51) Int. Cl.: H01L 27/108, H01L 21/8242

(54) **Verfahren zur Herstellung einer DRAM-Zellenanordnung**
Process of fabricating a DRAM cell array
Procédé de fabrication d'un réseau de cellules DRAM

(30) Priorität: 12.01.1998 DE 19800752
(43) Veröffentlichungstag der Anmeldung: 14.07.1999
(73) Patentinhaber: Infineon Technologies AG, 81669 München (DE)
(72) Erfinder: Krautschneider, Wolfgang, Dr., 83104 Hohenthann (DE); Risch, Lothar, Dr., 85579 Neubiberg (DE); Hofmann, Franz, Dr., 80995 München (DE); Rösner, Wolfgang, Dr., 81739 München (DE)
(74) Vertreter: Reinhard - Skuhra - Weise & Partner

(56) Entgegenhaltungen:
- DE-C- 19 519 160
- US-A- 5 236 858
- INABA T ET AL: "A 250 MV BIT-LINE SWING SCHEME FOR 1-V OPERATING GIGABIT SCALE DRAMS" IEICE TRANSACTIONS ON ELECTRONICS, Bd. E79-C, Nr. 12, Dezember 1996, Seiten 1699-1705, XP000692119

## Beschreibung

Die Erfindung betrifft eine DRAM-Zellenanordnung, d.h. eine Speicherzellen-Anordnung mit dynamischem wahlfreiem Zugriff, und ein Verfahren zu deren Herstellung.

Bei der Entwicklung von DRAM-Zellenanordnungen wird eine Erhöhung der Packungsdichte angestrebt. In DRAM-Zellenanordnungen werden derzeit fast ausschließlich sog. Eintransistor-Speicherzellen eingesetzt. Eine Eintransistor-Speicherzelle umfaßt einen Transistor und einen Kondensator. Im Kondensator ist die Information in Form einer elektrischen Ladung gespeichert, die eine logische Größe, 0 oder 1, darstellt. Durch Ansteuerung des Transistors über eine Wortleitung kann diese Information über eine Bitleitung ausgelesen werden. Meist ist der Transistor zwischen der Bitleitung und dem Kondensator geschaltet (siehe z.B. DE 195 19 160). Die Ladung auf einer ersten Kondensatorelektrode des Kondensators, die mit dem Transistor verbunden ist, bestimmt beim Auslesen der Information die Spannung an der Bitleitung. Eine zweite Kondensatorelektrode des Kondensators, die nicht mit dem Transistor verbunden ist, wird konstant auf die Hälfte der Betriebsspannung gehalten. Der Information entspricht ein Spannungssignal, das durch die Differenz der Spannung an der Bitleitung und der Hälfte der Betriebsspannung gebildet wird. Die Ladung auf der zweiten Kondensatorelektrode bleibt unbenutzt.

Aus US 4 630 088 ist eine DRAM-Zellenanordnung bekannt, bei der ein Kondensator zwischen einer Bitleitung und einem Transistor geschaltet ist. Hier wird die Ladung einer Kondensatorelektrode, die mit der Bitleitung verbunden ist, zur Bildung eines Spannungssignals, dem die Information entspricht, verwendet.

In T. Inaba et al, 250 mV Bit-Line Swing Scheme for a 1V 4 Gb DRAM, 1995 Symposium on VLSI Circuits Digest of Technical Papers, Seite 99 und 100, wird eine DRAM-Zellenanordnung vorgeschlagen, bei der ein Transistor mit einer ersten Bitleitung und ein Kondensator mit einer zweiten Bitleitung verbunden sind. Ein Spannungssignal, dem die Information entspricht, wird durch die Differenz der Spannungen der beiden Bitleitungen, und damit effektiv durch die Ladungen auf beiden Kondensatorelektroden erzeugt. Bei der Ladung des Kondensators wird die Betriebsspannung entweder an die erste Bitleitung oder an die zweite Bitleitung angelegt. An die jeweils andere Bitleitung wird 0V angelegt. Die zweite Bitleitung wird in einer Vertiefung angeordnet und dient als Kondensatorelektrode. Die erste Bitleitung und die zweite Bitleitung verlaufen parallel zueinander. Durch die Verwendung beider Ladungen statt einer Ladung des Kondensators und durch die beschriebene Ansteuerung der Bitleitungen bei der Ladung des Kondensators ist für dieselbe Stärke des Spannungssignals eine kleinere Betriebsspannung erforderlich als bei den DRAM-Zellenanordnungen mit nur einer Bitleitung. Eine kleinere Betriebsspannung bedeutet weniger Verlustleistung und erlaubt eine höhere Packungsdichte der DRAM-Zellenanordnung.

Aus den Patentschriften DE 195 19 160 und DE 196 37 389 ist bekannt, Wortleitungen einer DRAM-Zellenanordnung selbstjustiert, d.h. ohne Verwendung von zu justierenden Masken, zu erzeugen. Dazu werden parallel zueinander verlaufende, erste Gräben erzeugt, die durch Abscheiden und Rückätzen von Material verengt werden. Senkrecht zu den ersten Gräben werden zweite Gräben erzeugt, deren Breite mit der ursprünglichen Breite der ersten Gräben übereinstimmt. Die verengten ersten Gräben sind demnach enger als die zweiten Gräben. Zur Erzeugung der Wortleitungen wird Material abgeschieden und rückgeätzt, wodurch selbstjustiert parallel zu den zweiten Gräben verlaufende Wortleitungen entstehen, die Transistoren ringförmig umgeben.

In Y. Nishioka et al, Giga-bit Scale DRAM Cell with New Simple Ru/(Ba, Sr)TiO₃/Ru Stacked Capacitors Using X-ray Lithography, IEDM 95, Seite 903, ist eine DRAM-Zellenanordnung beschrieben, bei der ein Transistor zwischen einem Kondensator und einer Bitleitung geschaltet ist. Der Kondensator ist über dem Transistor angeordnet. Voneinander getrennte Kondensatorelektroden sind mit einem Kondensatordielektrikum versehen, an das eine Kondensatorplatte angrenzt.

In US-A-5 236 858 ist eine DRAM-Zellenanordnung beschrieben, bei der eine Bitleitung über einem Transistor angeordnet wird und als Kondensatorelektrode dient.

Der Erfindung liegt das Problem zugrunde, eine DRAM-Zellenanordnung anzugeben, die in der für die 1GBit-Generation erforderlichen Packungsdichte herstellbar ist. Ferner soll ein Verfahren zur Herstellung einer solchen DRAM-Zellenanordnung angegeben werden.

Dieses Problem wird gelöst durch ein Verfahren zur Herstellung einer DRAM-Zellenanordnung gemäß Anspruch 1. Weitere Ausgestaltungen der Erfindung gehen aus den übrigen Ansprüchen hervor.

Bei einer erfindungsgemäßen hergestellten DRAM-Zellenanordnung sind eine obere Bitleitung oberhalb eines Kondensators und der Kondensator oberhalb eines Transistors angeordnet. Flanken einer mit dem Transistor verbundenen ersten Kondensatorelektrode des Kondensators sind mit einem Kondensatordielektrikum versehen. Die obere Bitleitung grenzt an das Kondensatordielektrikum an und umgibt die erste Kondensatorelektrode ringförmig. Die obere Bitleitung dient auch als zweite Kondensatorelektrode. Eine Ladung auf der zweiten Kondensatorelektrode erzeugt beim Auslesen einer gespeicherten Information ein Spannungssignal, dem die Information entspricht.

Es ist vorteilhaft, wenn eine zusätzliche untere Bitleitung vorgesehen ist. Der Transistor ist dann zwischen der ersten Kondensatorelektrode und der unteren Bitleitung geschaltet. Die untere Bitleitung verläuft unterhalb und parallel zu der oberen Bitleitung. Durch die Verwendung zweier Bitleitungen kann, wie weiter oben erläutert, eine kleinere Betriebsspannung verwendet werden. Statt die Betriebsspannung zu verkleinern kann das Spannungssignal vergrößert werden. Es kann auch sowohl die Betriebsspannung verkleinert als auch das Spannungssignal vergrößert werden.

Wird auf die untere Bitleitung verzichtet, kann ein Source/Drain-Gebiet des Transistors an ein konstantes Potential, das in der Regel die Hälfte der Betriebsspannung beträgt, angeschlossen werden.

Es sind parallel zueinander verlaufende erste Gräben und quer zu den ersten Gräben verlaufende zweite Gräben vorgesehen, die zueinander benachbarte erste Kondensatorelektroden voneinander trennen und in denen obere Bitleitungen der DRAM-Zellenanordnung angeordnet sind. Die ersten Gräben sind zwischen ersten Kondensatorelektroden, die entlang der oberen Bitleitung zueinander benachbart sind, angeordnet. Die ersten Gräben verlaufen also quer zur oberen Bitleitung. Die zweiten Gräben sind zwischen quer zur oberen Bitleitung benachbarten ersten Kondensatorelektroden angeordnet. Die zweiten Gräben verlaufen also im wesentlichen parallel zur oberen Bitleitung.

Die ersten Gräben sind enger als die zweiten Gräben. Die DRAM-Zellenanordnung kann mit einem im Vergleich zum Stand der Technik kleinen Prozeßaufwand bei zugleich hoher Pakkungsdichte hergestellt werden. Nach Erzeugung des Kondensatordielektrikums wird die obere Bitleitung selbstjustiert erzeugt, indem Material abgeschieden und geätzt wird. Dabei ist die Dicke des abgeschiedenen Materials derart, daß das Material die ersten Gräben aber nicht die zweite Gräben füllt. Es wird geätzt, bis Böden jedes zweiten Grabens teilweise freigelegt werden. Dadurch entsteht selbstjustiert und parallel zu den zweiten Gräben die obere Bitleitung. Sie umgibt die erste Kondensatorelektrode ringförmig. Die selbstjustierte Erzeugung bedeutet zum einen eine Prozeßvereinfachung, da keine lithographisch strukturierte Masken erzeugt werden. Zum anderen erlaubt sie eine Erhöhung der Packungsdichte, da die mit der Verwendung von Masken einhergehende erforderliche Berücksichtigung von Justiertoleranzen entfällt.

Zur Erzeugung der ersten Kondensatorelektroden kann zunächst eine Schicht erzeugt werden. Die Schicht wird durch die ersten Gräben und die zweiten Gräben strukturiert. Die ersten Gräben und die zweiten Gräben durchtrennen die Schicht. Aus der strukturierten Schicht entstehen die voneinander getrennten ersten Kondensatorelektroden.

Es liegt im Rahmen der Erfindung, die ersten Gräben im Laufe des Verfahrens zu verengen. Im diesem Fall können die ersten Gräben zunächst mit z.B. der Breite der zweiten Gräben erzeugt werden, und anschließend verengt werden. Besonders vorteilhaft ist ein solches Verfahren, um eine hohe Packungsdichte zu erzielen, da die ersten Gräben und die zweiten Gräben zunächst mit einer Breite erzeugt werden, die der minimalen, in der verwendeten Technologie herstellbaren Strukturgröße entspricht.

Die Verengung der ersten Gräben kann erzielt werden, indem vor Erzeugung der zweiten Gräben die ersten Gräben verengt werden, indem Material abgeschieden und rückgeätzt wird, bis an Flanken der ersten Gräben Spacer entstehen. Die Spacer werden vorzugsweise aus demselben Material wie aus dem Material der Schicht erzeugt.

Sind die Spacer aus leitendem Material, so wirken sie als Teile der ersten Kondensatorelektroden. In diesem Fall sind Abstände zwischen entlang der oberen Bitleitung zueinander benachbarten ersten Kondensatorelektroden kleiner als Abstände zwischen quer zur oberen Bitleitung zueinander benachbarten ersten Kondensatorelektroden.

Bestehen die Spacer aus nichtleitendem Material, so wirken sie nicht als Teile der ersten Kondensatorelektroden.

Um eine hohe Packungsdichte zu erzielen, ist es vorteilhaft, wenn Abstände zwischen Mittellinien benachbarter erster Gräben und Abstände zwischen Mittellinien benachbarter zweiter Gräben gleichgroß sind und ebenfalls der minimalen, in der verwendeten Technologie herstellbaren Strukturgröße entsprechen. Abstände zwischen Mittelpunkten von ersten Kondensatorelektroden, die entlang der oberen Bitleitung zueinander benachbart sind, sind dann gleich Abständen zwischen Mittelpunkten von ersten Kondensatorelektroden, die quer zur oberen Bitleitung zueinander benachbart sind.

Zur Vergrößerung der Kapazität des Kondensators ist es vorteilhaft, wenn die obere Bitleitung die erste Kondensatorelektrode bedeckt. Dazu wird beispielsweise nach Erzeugung des Kondensatordielektrikums ein erstes Material abgeschieden, bis die ersten Gräben aber nicht die zweiten Gräben gefüllt werden. Durch Abscheiden eines zweiten Materials werden anschließend die zweiten Gräben gefüllt. Durch Rückätzen des zweiten Materials werden außerhalb der zweiten Gräben befindliche Teile des ersten Materials sowie im Bereich der Flanken der zweiten Gräben befindliche Teile des ersten Materials freigelegt. Durch thermische Oxidation entstehen an den freigelegten Teilen des ersten Materials Hilfsstrukturen. Anschließend wird das zweite Material entfernt, indem es selektiv zu den Hilfsstrukturen geätzt wird. Durch anisotropes Ätzen vom ersten Material selektiv zu den Hilfsstrukturen entstehen aus dem ersten Material die oberen Bitleitungen, die aufgrund der schützenden Wirkung der Hilfsstrukturen beim Ätzen die ersten Kondensatorelektroden bedecken. Die Hilfsstrukturen wirken als Maske, die ohne Lithographie, d.h. selbstjustiert bezüglich den ersten Kondensatorelektroden erzeugt wird.

Es liegt im Rahmen der Erfindung, die Hilfsstrukturen durch andere Verfahren aus Teilen des ersten Materials zu erzeugen. Wichtig ist, daß das erste Material selektiv zu den Hilfsstrukturen entfernt werden kann.

Zur Erhöhung der Packungsdichte ist es vorteilhaft, wenn der Transistor ein vertikaler Transistor ist.

Im folgenden wird die Erfindung anhand eines Ausführungsbeispiels, das in den Figuren dargestellt ist, näher erläutert.
- Figur 1: zeigt einen Querschnitt durch eine Schicht, die auf eine isolierende Struktur mit Kontakten aufgebracht wurde, nachdem erste Gräben und Spacer erzeugt wurden. In dieser Figur sind eine untere Bitleitung und Positionen von Transistoren schematisch dargestellt. Die untere Bitleitung und die Positionen der Transistoren sind in den folgenden Figuren nicht mehr dargestellt.
- Figur 2: zeigt einen zum Querschnitt aus Figur 1 senkrechten Querschnitt durch die Schicht, nachdem zweite Gräben erzeugt wurden und aus der Schicht erste Kondensatorelektroden erzeugt wurden.
- Figur 3a: zeigt den Querschnitt aus Figur 1 nach den Prozeßschritten aus Figur 2 und nachdem ein Kondensatordielektrikum, eine dünne Schicht und eine erste Hilfsstruktur erzeugt wurden.
- Figur 3b: zeigt den Querschnitt aus Figur 2 nach den Prozeßschritten aus Figur 3a.
- Figur 4: zeigt den Querschnitt aus Figur 3b, nachdem eine zweite Hilfsstruktur erzeugt wurde, die erste Hilfsstruktur entfernt wurde und obere Bitleitungen erzeugt wurden.
- Figur 5: zeigt einen zum Querschnitt aus Figur 3a und zum Querschnitt aus Figur 3b senkrechten Querschnitt durch die Schicht nach den Prozeßschritten aus Figur 4.

Die Figuren sind nicht maßstabsgetreu.

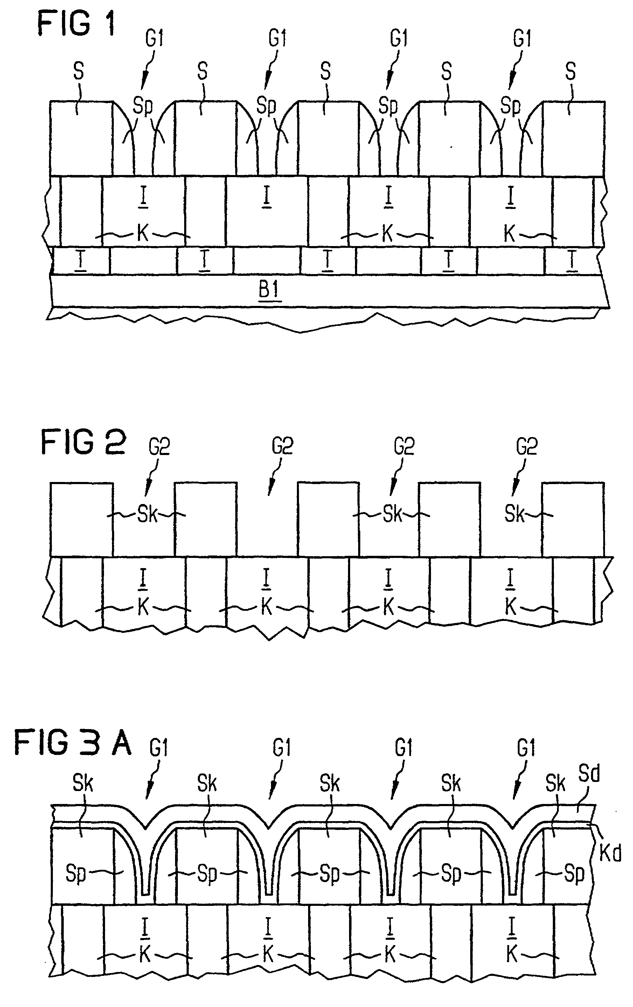

Im Ausführungsbeispiel werden Transistoren T, die mit unteren Bitleitungen B1 verbunden werden, erzeugt. Quer zu den unteren Bitleitungen B1 verlaufende Wortleitungen (nicht dargestellt) werden mit Gateelektroden der Transistoren T verbunden. Über den Transistoren T, den unteren Bitleitungen B1 und den Wortleitungen wird eine isolierende Struktur I erzeugt. In der isolierenden Struktur I werden Kontakte K erzeugt, die jeweils mit einem der Transistoren T verbunden werden. Zur Erzeugung einer Schicht S wird Rutenium in einer Dicke von ca. 400 nm abgeschieden (siehe Figur 1). Durch Ätzen mit z.B. CCl₂F₂, O₂, Ar werden in der Schicht S parallel zueinander verlaufende erste Gräben G1 erzeugt (siehe Figur 1), die die Schicht S durchtrennen. Die ersten Gräben G1 sind ca. 200 nm breit. Abstände von Mittellinien benachbarter erster Gräben G1 betragen ca. 200 nm. Zur Verengung der ersten Gräben G1 wird Rutenium in einer Dicke von ca. 50 nm abgeschieden und mit z.B. CCl₂F₂, O₂, Ar rückgeätzt, bis an Flanken der ersten Gräben G1 Spacer Sp entstehen (siehe Figur 1).

Durch maskiertes Ätzen mit z.B. CCl₂F₂, O₂, Ar werden senkrecht zu den ersten Gräben G1 verlaufende zweite Gräben G2, die die Schicht S durchtrennen, geätzt (siehe Figur 2). Aus der Schicht S und aus den Spacern Sp entstehen dadurch im wesentlichen quaderförmige erste Kondensatorelektroden Sk. Die ersten Kondensatorelektroden Sk sind über die Kontakte K mit den Transistoren T verbunden.

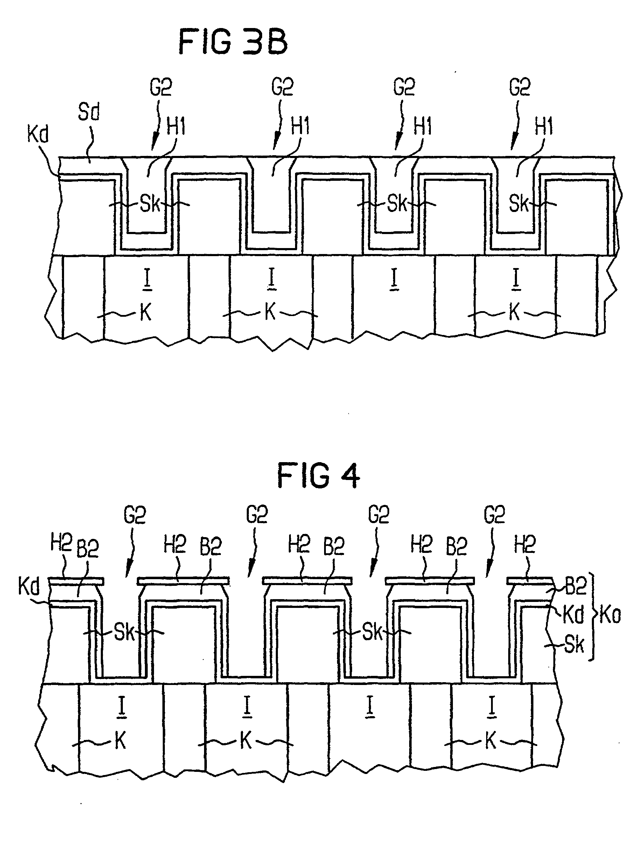

Zur Erzeugung eines Kondensatordielektrikums Kd wird z.B. BST (Bariumstrontiumtitanat) in einer Dicke von ca. 10 nm abgeschieden (siehe Figur 3a und 3b). Das Kondensatordielektrikum Kd bedeckt Flanken und eine obere Seite der ersten Kondensatorelektroden Sk. Zur Erzeugung einer dünnen Schicht Sd wird insitu dotiertes Polysilizium in einer Dicke von ca. 50 nm abgeschieden. Die dünne Schicht Sd füllt die ersten Gräben G1 (siehe Figur 3a), nicht aber die zweiten Gräben G2 (siehe Figur 3b). Kondensatoren Ko werden jeweils durch eine der ersten Kondensatorelektroden Sk, einen Teil des Kondensatordielektrikums Kd und einen Teil der dünnen Schicht Sd gebildet.

Zur Erzeugung streifenförmiger erster Hilfsstrukturen H1 wird Siliziumnitrid in einer Dicke von ca. 100 nm abgeschieden, durch chemisch mechanisches Polieren planarisiert und anschließend geätzt, bis die dünne Schicht Sd teilweise freigelegt wird. Die dünne Schicht Sd wird außerhalb der zweiten Gräben G2 und im Bereich der Flanken der zweiten Gräben G2 freigelegt. Die zweiten Gräben G2 sind durch die ersten Hilfsstrukturen H1 gefüllt (siehe Figur 3b).

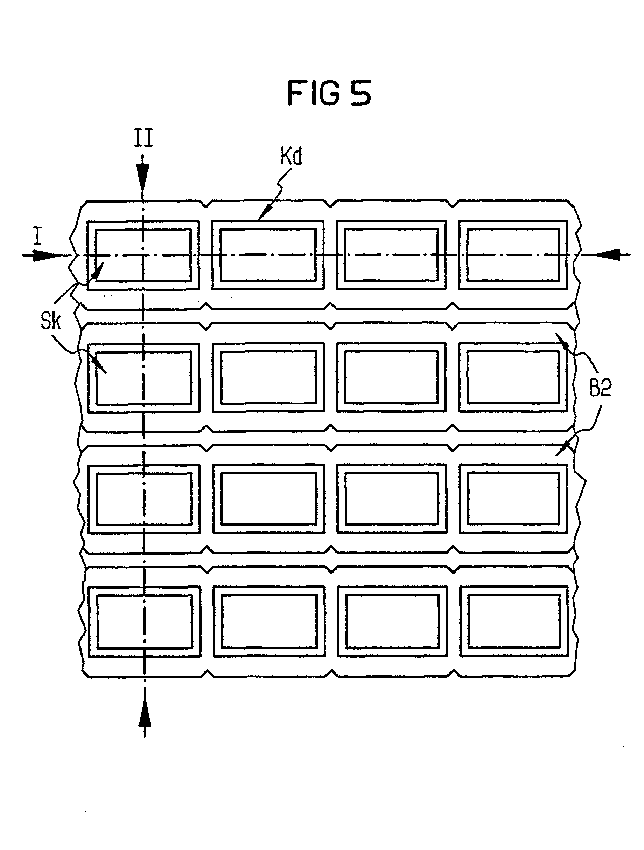

Durch thermische Oxidation wird aus oberen Teilen der freiliegenden Teile der dünnen Schicht Sd eine zweite Hilfsstruktur H2 aus SiO₂ erzeugt (siehe Figur 4). Anschließend wird mit z.B. H₃PO₄ Siliziumnitrid selektiv zu SiO₂ geätzt, bis die ersten Hilfsstrukturen H1 entfernt werden. Teile der dünnen Schicht Sd innerhalb der zweiten Gräben G2 werden dadurch freigelegt. Durch Ätzen von Polysilizium selektiv zu SiO₂ mit z.B. He, HBr, Cl₂, C₂F₆ wird die dünne Schicht Sd teilweise entfernt, bis innerhalb der zweiten Gräben G2 befindliche Teile des Kondensatordielektrikums Kd freigelegt werden. Dadurch entstehen aus der dünnen Schicht Sd parallel zu den zweiten Gräben G2 verlaufende, obere Bitleitungen B2, die die mit dem Kondensatordielektrikum Kd versehenen ersten Kondensatorelektroden Sk ringförmig umgeben und bedecken (s. Figur 4 und 5). Die oberen Bitleitungen B2 dienen teilweise als zweite Kondensatorelektroden, die Teile der Kondensatoren Ko sind.

Es sind viele Variationen des Ausführungsbeispiels denkbar, die ebenfalls im Rahmen der Erfindung liegen. Insbesondere können die Abmessungen der beschriebenen Schichten, Gräben und Strukturen an die jeweiligen Erfordernisse angepaßt werden.

Polysilizium kann sowohl während als auch nach der Abscheidung dotiert werden.

Statt dotiertes Polysilizium für die dünne Schicht zu verwenden, lassen sich auch andere leitende Materialien, wie z.B. Metallsilizide und/oder Metalle, verwenden, die durch Oxidation oder durch Abscheiden einer geeigneten Schicht chemisch umgewandelt werden können, damit die zweiten Hilfsstrukturen erzeugt werden können.

Statt Rutenium für die ersten Kondensatorelektroden zu verwenden, lassen sich auch andere leitende Materialien verwenden. Beispiele hierfür sind: Metall-Nitride, wie z.B. Titannitrid, Halbleitermaterialien, Metalle, wie z.B. Wolfram, oder Metallsilizide.

Auf die unteren Bitleitungen kann verzichtet werden.

## Patentansprüche

1. Verfahren zum Herstellen einer DRAM-Zellenanordnung mit den Schritten:
- Erzeugen von einer Mehrzahl von Transistoren (T) in einer ersten Ebene;
- Erzeugen von einer entsprechenden Mehrzahl von gegenseitig isolierten Kontakten (K) in einer darüberliegenden zweiten Ebene, die jeweils mit einem der Transistoren (T) verbunden sind;
- Abscheiden einer Schicht (S) aus einem ersten leitenden Material in einer darüberliegenden dritten Ebene, wobei die Schicht (S) in Verbindung mit den Kontakten (K) steht;
- Erzeugen von im wesentlichen parallel zueinander verlaufenden ersten Gräben (G1), die die Schicht (S) durchtrennen;
- Verengen der ersten Gräben (G1) durch Bilden von leitenden Spacern (Sp) aus dem ersten leitenden Material an ihren Seitenwänden;
- Erzeugen von im wesentlichen parallel zueinander verlaufenden zweiten Gräben (G2) quer zu den ersten Gräben (G1), die die Schicht (S) durchtrennen, wobei die verengten ersten Gräben (G1) enger als die zweiten Gräben (G2) sind und die Schicht (S) durch die ersten und zweiten Gräben (G1, G2) in eine Mehrzahl erster Kondensatorelektroden (Sk) unterteilt wird;
- Erzeugen eines Kondensatordielektrikums (Kd) an den Flanken und der Oberseite der ersten Kondensatorelektroden (Sk);
- Abscheiden einer Schicht (Sd) aus einem zweiten leitenden Material in solch einer Dicke, daß die ersten Gräben (G1) aber nicht die zweiten Gräben (G2) damit gefüllt werden;
- Abscheiden eines ersten Hilfsmaterials, wodurch die zweiten Gräben (G2) mit ersten Hilfsstrukturen (H1) gefüllt werden;
- Entfernen des ersten Hilfsmaterials von der Oberfläche, so daß das zweite leitende Material außerhalb der zweiten Gräben (G2) teilweise freigelegt wird;
- Erzeugen zweiter Hilfsstrukturen (H2) auf der Oberfläche der freiliegenden Teile des zweiten leitenden Materials;
- selektives Entfernen der ersten Hilfsstrukturen (H1) aus den zweiten Gräben (G2);
- selektives Entfernen des zweiten leitenden Materials von den Böden der zweiten Gräben (G2), um voneinander getrennte parallel zu den zweiten Gräben (G2) verlaufende obere Bitleitungen (B2) zu erzeugen, die als zweite Kondensatorelektroden dienen und die mit dem Kondensatordielektrikum (Kd) bedeckten ersten Kondensatorelektroden (Sk) ringförmig umgeben und bedecken.

2. Verfahren nach Anspruch 1,
**dadurch gekennzeichnet,**
**daß** der Abstand zwischen Mittellinien benachbarter erster Gräben (G1) gleich dem Abstand zwischen Mittellinien benachbarter zweiter Gräben (G2) gestaltet wird.

3. Verfahren nach Anspruch 1 oder 2,
**dadurch gekennzeichnet,**
**daß** die zweiten Hilfsstrukturen (H2) durch Oxiadation der Oberfläche der freiliegenden Teile des zweiten leitenden Materials erzeugt werden.

4. Verfahren nach Anspruch 1, 2 oder 3,
**dadurch gekennzeichnet,**
**daß** das selektive Entfernen der ersten Hilfsstrukturen (H1) aus den zweiten Gräben (G2) und/oder das selektives Entfernen des zweiten leitenden Materials von den Böden der zweiten Gräben (G2) durch einen Ätzprozeß durchgeführt wird.

5. Verfahren nach einem der vorhergehenden Ansprüche,
**dadurch gekennzeichnet,**
**daß** das Entfernen des ersten Hilfsmaterials durch chemischmechanisches Polieren und durchgeführt wird.

6. Verfahren nach einem der vorhergehenden Ansprüche,
**dadurch gekennzeichnet,**
**daß** in einer vierten Ebene unterhalb der Transistoren (T) untere Bitleitungen (B1) gebildet werden.

## Claims

1. Method for fabricating a DRAM cell arrangement, comprising the following steps:
- producing a plurality of transistors (T) in a first plane;
- producing a corresponding plurality of mutually insulated contacts (K) in a second plane which lies above the first plane, these contacts each being connected to one of the transistors (T);
- depositing a layer (S) of a first conductive material in a third plane, which lies above the second plane, the layer (S) being connected to the contacts (K);
- producing first trenches (G1) which run substantially parallel to one another and pass all the way through the layer (S);
- narrowing the first trenches (G1) by forming conductive spacers (Sp) from the first conductive material on their side walls;
- producing second trenches (G2), which run substantially parallel to one another, transversely with respect to the first trenches (G1), which pass all the way through the layer (S), the narrowed first trenches (G1) being narrower than the second trenches (G2) and the layer (S) being divided into a plurality of first capacitor electrodes (Sk) by the first and second trenches (G1, G2);
- producing a capacitor dielectric (Kd) on the flanks and the upper side of the first capacitor electrodes (Sk);
- depositing a layer (Sd) of a second conductive material in a thickness which is such that it fills the first trenches (G1) but not the second trenches (G2);
- depositing a first auxiliary material, so that the second trenches (G2) are filled with first auxiliary structures (H1);
- removing the first auxiliary material from the surface, so that the second conductive material is partially exposed outside the second trenches (G2);
- producing second auxiliary structures (H2) on the surface of the exposed parts of the second conductive material;
- selectively removing the first auxiliary structures (H1) from the second trenches (G2);
- selectively removing the second conductive material from the bases of the second trenches (G2), in order to produce upper bit lines (B2) which are separate from one another, run parallel to the second trenches (G2), serve as second capacitor electrodes and cover and surround the first capacitor electrodes (Sk), which are covered with the capacitor dielectric (Kd), in the form of a ring.

2. Method according to Claim 1, **characterized in that** the distance between centre lines of adjacent first trenches (G1) is designed to be equal to the distance between centre lines of adjacent second trenches (G2).

3. Method according to Claim 1 or 2, **characterized in that** the second auxiliary structures (H2) are produced by oxidation of the surface of the exposed parts of the second conductive material.

4. Method according to Claim 1, 2 or 3, **characterized in that** the selective removal of the first auxiliary structures (H1) from the second trenches (G2) and/or the selective removal of the second conductive material from the bases of the second trenches (G2) is carried out by means of an etching process.

5. Method according to one of the preceding claims, **characterized in that** the removal of the first auxiliary material is carried out by chemical-mechanical polishing and [lacuna].

6. Method according to one of the preceding claims, **characterized in that** lower bit lines (B1) are formed in a fourth plane, below the transistors (T).

## Revendications

1. Procédé pour fabriquer un réseau de cellules de mémoire DRAM comportant les étapes consistant à:
- fabriquer une multiplicité de transistors (T) dans un premier plan;
- fabriquer une multiplicité correspondante de contacts (K), réciproquement isolés, qui sont reliés chacun à l'un des transistors (T), dans un second plan supérieur;
- dépôt d'une couche (S) formée d'un premier matériau conducteur dans un troisième plan supérieur, la couche (5) étant reliée aux contacts (K);
- produire des premiers sillons (G1), qui sont essentiellement parallèles et traversent la couche (S);
- rétrécir les premiers sillons (G1) par formation d'entretoises conductrices (Sp) formées du premier matériau conducteur, au niveau de leurs parois latérales;
- produire des seconds sillons (G2) essentiellement parallèles entre eux, transversalement par rapport aux premiers sillons, qui traversent la couche (S), les premiers sillons rétrécis (G1) étant plus étroits que les seconds sillons (G2), et la couche (S) étant subdivisée par les premiers et seconds sillons (G1, G2) en une multiplicité de premières électrodes (Sk) de condensateurs;
- fabriquer un diélectrique de condensateur (Kd) au niveau des flancs et de la face supérieure des premières électrodes de condensateurs (Sk) ;
- déposer une couche (Sd) formée d'un second matériau conducteur sur une épaisseur telle que les premiers sillons (G1) sont complètement remplis mais pas les seconds sillons (G2) ;
- déposer un premier matériau auxiliaire, ce qui remplit le seconds sillons (G2) avec des premières structures auxiliaires (H1);
- retirer le premier matériau auxiliaire de la surface de sorte que le second matériau conducteur est partiellement mis à nu à l'extérieur des seconds sillons (G2) ;
- former des secondes structures auxiliaires (H2) sur la surface des parties mises à nu du second matériau conducteur;
- éliminer sélectivement les premières structures auxiliaires (H1), des seconds sillons (G2) ;
- éliminer sélectivement le second matériau conducteur du fond des seconds sillons (G2) pour produire des lignes supérieures de bits (B2) séparées les unes des autres et parallèles aux seconds sillons (G1) et qui sont utilisées comme secondes électrodes de condensateurs et qui entourent selon une forme annulaire et recouvrent les premières électrodes (Sk) de condensateurs, recouvertes par le diélectrique (Kd) de condensateur.

2. Procédé selon la revendication 1, **caractérisé en ce que** la distance entre les lignes médianes de premiers sillons voisins (G1) est égale à la distance entre des lignes médianes de seconds sillons voisins (G2).

3. Procédé selon la revendication 1 ou 2, **caractérisé en ce qu'**on forme les secondes structures auxiliaires (H2) par oxydation de la surface des parties mises à nu du second matériau conducteur.

4. Procédé selon la revendication 1, 2 ou 3, **caractérisé en ce que** l'élimination sélective des premières structures auxiliaires (H1) à partir des seconds sillons (G2) et/ou l'élimination sélective du second matériau conducteur à partir des fonds des seconds sillons (G2) est réalisée au moyen d'un processus d'attaque chimique.

5. Procédé selon l'une des revendications précédentes, **caractérisé en ce que** l'élimination du premier matériau auxiliaire est exécutée par polissage chimique et mécanique.

6. Procédé selon l'une des revendications précédentes, **caractérisé en ce que** des lignes inférieures de bits (B1) sont formées dans un quatrième plan au-dessous des transistors (T).
